# EUROPÄISCHE PATENTSCHRIFT

(11) **EP 0 707 384 B1**
(45) Veröffentlichungstag und Bekanntmachung des Hinweises auf die Patenterteilung: **27.10.1999**
(21) Anmeldenummer: 95111727.4
(22) Anmeldetag: 26.07.1995
(51) Int. Cl.: H03M 1/06, G01D 5/249, H03M 1/26

(54) **Positionsmesseinrichtung**
Position measuring device
Dispositif de mesure de position

(30) Priorität: 13.10.1994 DE 4436496
(43) Veröffentlichungstag der Anmeldung: 17.04.1996
(73) Patentinhaber: Dr. Johannes Heidenhain GmbH, 83292 Traunreut (DE)
(72) Erfinder: Strasser, Erich, D-83308 Trostberg (DE)

(56) Entgegenhaltungen:
- EP-A- 0 212 118
- DE-A- 3 734 938
- DE-A- 4 120 343
- US-A- 4 183 014

## Beschreibung

Die Erfindung betrifft eine Positionsmeßeinrichtung nach dem Oberbegriff des Anspruches 1.

Aus der DE 33 22 897 C2 ist eine Positionsmeßeinrichtung bekannt, bei der mehrere Codescheiben über ein Untersetzungsgetriebe miteinander gekoppelt sind, um eine Position über mehrere Umdrehungen absolut zu messen. Die Codespuren einer Codescheibe bilden jeweils eine Codegruppe, durch dessen Abtastung ein Codewort entsteht. Durch Kombination der einzelnen Codewörter unterschiedlicher Winkelauflösung wird die Absolutposition ermittelt. Um die Auswirkungen eines Getriebespiels zu unterdrükken, sind Maßnahmen bekannt geworden, um eine Synchronisation zwischen den Abtastsignalen zweier aufeinanderfolgender Codegruppen zu erreichen. Diese Maßnahmen sind in der DE 33 22 897 C2, der DE 37 34 938 C2, der DE 29 38 318 C3 sowie der DE 27 58 525 B1 ausführlich erläutert, worauf ausdrücklich Bezug genommen wird.

Bei all diesen Maßnahmen ist eine korrekte Synchronisation zwischen den Abtastsignalen zweier Codegruppen nur gewährleistet, wenn der Versatz zwischen einer Fein-Codegruppe und einer nachfolgenden Grob-Codegruppe kleiner ist als eine halbe Teilungsperiode der gröbsten Codespur der Fein-Codegruppe. Das bedeutet, daß das Umkehrspiel des Untersetzungsgetriebes sich innerhalb der Breite eines Bits der höher auflösenden Codegruppe verschieben darf, ohne daß ein Meßfehler auftritt. Bei einem größeren Getriebespiel ist keine Synchronisation möglich, wodurch keine korrekten Positionsmeßwerte ausgegeben werden können.

Aufgabe der Erfindung ist es, eine Positionsmeßeinrichtung anzugeben, bei der Fehlmessungen rechtzeitig erkannt werden.

Diese Aufgabe wird durch die Merkmale des Anspruches 1 gelöst.

Vorteilhafte Ausgestaltungen der Erfindung sind in den abhängigen Ansprüchen angegeben.

Mit Hilfe der Zeichnungen werden Einzelheiten und Vorteile der Erfindung näher erläutert.

Es zeigt
- Figur 1: eine Winkelmeßeinrichtung mit zwei Codescheiben und
- Figur 2: Abtastsignale der Winkelmeßeinrichtung gemäß Figur 1.

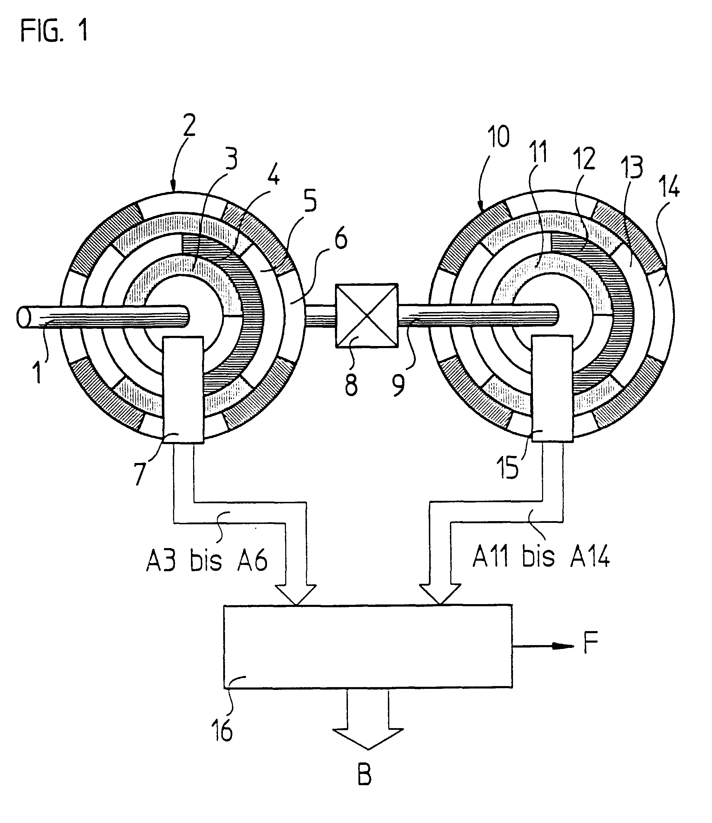

Die Winkelmeßeinrichtung gemäß Figur 1 besteht aus einer Eingangswelle 1, an der eine erste Codescheibe 2 mit vier Codespuren 3, 4, 5 und 6 angebracht ist, die in bekannter Weise mit einer Abtasteinheit 7 lichtelektrisch abgetastet wird, um die Absolutposition der Eingangswelle 1 innerhalb einer Umdrehung zu bestimmen.

Die Eingangswelle 1 ist über ein Untersetzungsgetriebe 8 mit einer weiteren Welle 9 gekoppelt, an der eine zweite Codescheibe 10 angebracht ist. Diese Codescheibe 10 besitzt ebenfalls mehrere Codespuren 11, 12, 13 und 14, die mittels einer weiteren Abtasteinheit 15 lichtelektrisch abgetastet werden. Die Codierung erfolgt vorzugsweise im Gray-Code. Alle Codespuren 3 bis 6 der ersten Codescheibe 2 bilden eine erste Codegruppe und alle Codespuren 11 bis 14 der zweiten Codescheibe 10 eine weitere Codegruppe, wobei die erste Codegruppe eine höhere Auflösung als die weitere Codegruppe aufweist.

Die in den Abtasteinheiten 7, 15 erzeugten analogen Abtastsignale werden getriggert und als digitale Abtastsignale A3 bis A6 sowie All bis A14 einer Auswerteeinheit 16 zur Bildung der Absolutposition B zugeführt. Die Bildung der Absolutposition B durch Synchronisation der Abtastsignale A3 bis A6 mit All bis A14 ist in den bereits einleitend genannten Schriften ausführlich erläutert, so daß zum Verständnis der Erfindung nur kurz darauf eingegangen wird.

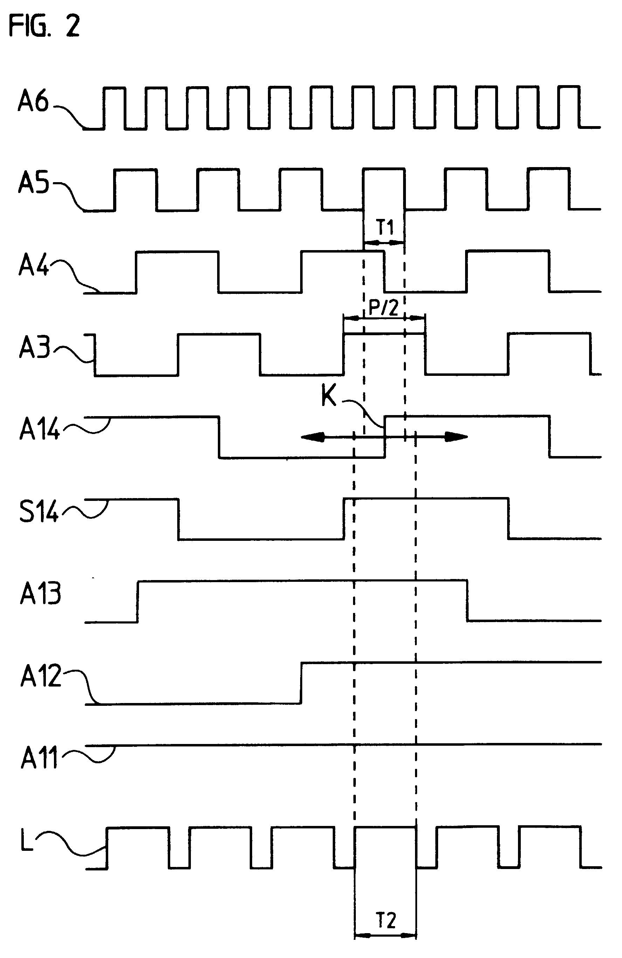

In Figur 2 sind die digitalisierten Abtastsignale A3 bis A6 der ersten Codegruppe dargestellt. Es ist ersichtlich, daß die ersten drei höchstauflösenden Abtastsignale A 4 bis A6 einen Gray-Code bilden und das vierte Abtastsignal A3 gegenüber dem dritten Abtastsignal A4 um 90° phasenverschoben ist, aber die gleiche Signalperiode wie das Abtastsignal A4 aufweist. Dieses Abtastsignal A3 dient zur Synchronisation, also zum korrekten Anschluß der Abtastsignale A3 bis A6 und A11 bis A14 beider Codegruppen. Die Codespur 3, welche zur Bildung des Abtastsignales A3 dient, wird deshalb auch als Anschlußspur bezeichnet.

Bei einem Getriebespiel des Getriebes 8 verschieben sich die Flanken der Abtastsignale A11 bis A14 gegenüber der Soll-Lage, was am Beispiel des Abtastsignales A14 dargestellt ist. Um ein unvermeidliches Getriebespiel zuzulassen, wird aus dem am gröbsten auflösenden Abtastsignal A3 der höher auflösenden Codegruppe und den Abtastsignalen A11 bis A14 der gröber auflösenden Codegruppe ein Abtastsignal S14 erzeugt, das mit den Abtastsignalen A6, A5, A4 einen korrekten Gray-Code bildet. Diese Synchronisation erfolgt mit Logikschaltungen oder mit Festwertspeichern gemäß dem Stand der Technik. Wie in der DE 37 34 938 C2 in Figur 2 anschaulich erläutert ist, ist eine korrekte Synchronisation nur möglich, wenn das Getriebespiel innerhalb einer halben Signalperiode P des am gröbsten auflösenden Abtastsignales A3 der höher auflösenden Codegruppe liegt. Bei dem Beispiel gemäß Figur 2 darf sich die ansteigende Flanke K des Abtastsignales A14 innerhalb von P/2 des Abtastsignales A3 verschieben. Ist die Verschiebung größer, erfolgt die Ausgabe eines falschen Positionsmeßwertes B.

Gemäß unserer Erfindung wird überprüft, ob die Flanke K innerhalb eines vorgegebenen Toleranzbereiches T liegt. Ein Toleranzbereich T1 wird beispielsweise durch ein höher auflösendes Abtastsignal A5 der höher auflösenden Codegruppe gebildet, indem überprüft wird, ob die Flanke K innerhalb eines vorgegeben logischen Pegels (beispielsweise 1) des Abtastsignales A5 liegt. Sobald die Flanke K innerhalb eines anderen Pegels (beispielsweise 0) des Abtastsignales A5 liegt, wird ein Warnsignal F von der Auswerteeinheit 16 abgegeben.

Eine weitere Möglichkeit zur Festlegung eines Toleranzbereiches T2 besteht darin, mehrere Abtastsignale A5 und A6 logisch miteinander zu verknüpfen. Durch ODER-Verknüpfung entsteht ein Prüfsignal L. Sobald die Flanke K innerhalb des logischen Pegels 0 des Prüfsignals L gelangt, wird ein Warnsignal F erzeugt. Diese Überprüfung kann mittels eines Rechners oder mittels logischer Netzwerke erfolgen. Besonders vorteilhaft ist es, wenn die Auswerteeinheit 16 zur Bildung des Warnsignales F integrierender Bestandteil der Positionsmeßeinrichtung ist, so daß auch während des Betriebes beim Anwender eine Prüfung der korrekten Arbeitsweise erfolgen kann.

Die beiden zu synchronisierenden Codegruppen müssen nicht auf getrennten Maßverkörperungen 2, 10 aufgeteilt sein. Die Erfindung ist auch einsetzbar, um zwei Codegruppen unterschiedlicher Auflösung auf einer einzigen Maßverkörperung miteinander zu synchronisieren. Dies kann erforderlich sein, da sich die Flanke K eines Abtastsignales A14 allein durch frequenzabhängige Einflüsse relativ gegenüber dem Abtastsignal A3 verschieben kann. Diese Verschiebung erfolgt beispielsweise allein durch die Triggerung aufgrund der Frequenzabhängigkeit der Triggerstufen. Die Verschiebung wird sich bei schnellen Relativverschiebungen zwischen der Maßverkörperung und einer Abtasteinheit erhöhen, so daß gemäß der Erfindung auch eine Überwachung der zulässigen Geschwindigkeit, beispielsweise Drehzahl möglich ist.

Die Erfindung ist bei Winkel- sowie Linearmeßeinrichtungen einsetzbar, die auf dem lichtelektrischen, kapazitiven, induktiven oder magnetischen Abtastprinzip beruhen. Bei magnetischen Positionsmeßeinrichtungen enthalten die Abtasteinheiten 7, 15 magnetoresistive Elemente oder Hallelemente zur Erzeugung der Abtastsignale A3 bis A6 und A11 bis A14.

## Patentansprüche

1. Positionsmeßeinrichtung mit zumindest einer Abtasteinheit (7, 15) zum Abtasten mehrerer Codespuren (3, 4, 5, 6; 11, 12, 13, 14) unterschiedlicher Auflösung, welche mindestens zwei Codegruppen mit einer höher und einer gröber auflösenden Codegruppe bilden, so daß Abtastsignale (A3, A4, A5, A6; A11, A12, A13, A14) unterschiedlicher Signalperiode entstehen, dadurch gekennzeichnet, daß eine Verschiebung zwischen zumindest einem Abtastsignal (A3, A4, A5, A6) der höher auflösenden Codegruppe und einem Abtastsignal (A11, A12, A13, A14) der gröber auflösenden Codegruppe gegenüber einer Soll-Lage überwacht wird und bei Überschreiten eines vorgegebenen Toleranzbereiches (T1, T2) ein Warnsignal (F) abgegeben wird.

2. Positionsmeßeinrichtung nach Anspruch 1, dadurch gekennzeichnet, daß der Code der Codespuren (3, 4, 5, 6; 11, 12, 13, 14) ein Gray-Code ist.

3. Positionsmeßeinrichtung nach Anspruch 1 oder 2, dadurch gekennzeichnet, daß die Verschiebung einer Flanke (K) eines der Abtastsignale (A14) der gröber auflösenden Codegruppe überwacht wird, indem überprüft wird, ob die Flanke (K) innerhalb eines von zumindest einem der Abtastsignale (A5; A5, A6) der höher auflösenden Codegruppe bestimmten Toleranzbereiches (T1, T2) liegt.

4. Positionsmeßeinrichtung nach Anspruch 3, dadurch gekennzeichnet, daß der Toleranzbereich (T1) die halbe Signalperiode des Abtastsignales (A5) ist, welches die doppelte Frequenz des Abtastsignales (A3, A4) mit niedrigster Auflösung der höher auflösenden Codegruppe aufweist.

5. Positionsmeßeinrichtung nach Anspruch 3, dadurch gekennzeichnet, daß der Toleranzbereich (T2) durch logische Verknüpfung mehrerer Abtastsignale (A6, A5) der höher auflösenden Codegruppe bestimmt ist.

6. Positionsmeßeinrichtung nach Anspruch 5, dadurch gekennzeichnet, daß der Toleranzbereich (T2) durch eine logische ODER-Verknüpfung zwischen den zwei nächst höher auflösenden Abtastsignalen (A5, A6) bezüglich dem Abtastsignal (A3) mit niedrigster Auflösung der höher auflösenden Codegruppe bestimmt ist.

7. Positionsmeßeinrichtung nach einem der vorhergehenden Ansprüche, dadurch gekennzeichnet, daß die Auswerteeinheit (16) zur Bildung des Warnsignals (F) integraler Bestandteil der Meßeinrichtung ist.

## Claims

1. Position measuring device with at least one scanning unit (7, 15) for scanning several code tracks (3, 4, 5, 6; 11, 12, 13, 14) of a different resolution, said code tracks forming at least two code groups with a higher-resolution and a coarser-resolution code group so that scanning signals (AS, A4, A5, A6; A11, A12, A13, A14) of a different signal period occur, characterised in that a displacement between at least one scanning signal (A3, A4, A5, A6) of the higher-resolution code group and a scanning signal (A11, A12, A13, A14) of the coarser-resolution code group is monitored relative to a reference position and, when a pre-set tolerance range (T1, T2) is exceeded, a warning signal (F) is emitted.

2. Position measuring device according to claim 1, characterised in that the code of the code tracks (3, 4, 5, 6; 11, 12, 13, 14) is a Gray code.

3. Position measuring device according to claim 1 or 2, characterised in that the displacement of an edge (K) of one of the scanning signals (A14) of the coarser-resolution code group is monitored, an examination being made of whether the edge (K) lies within a tolerance range (T1, T2) which is determined by at least one of the scanning signals (A5; A5, A6) of the higher-resolution code group.

4. Position measuring device according to claim 3, characterised in that the tolerance range (T1) is half of the signal period of the scanning signal (A5) which has double the frequency of the scanning signal (A3, A4) with lowest resolution of the higher-resolution code group.

5. Position measuring device according to claim 3, characterised in that the tolerance range (T2) is determined via a logical linkage of several scanning signals (A6, A5) of the higher-resolution code group.

6. Position measuring device according to claim 5, characterised in that the tolerance range (T2) is determined by an OR logical sum between the two next higher of the higher-resolution scanning signals (A5, A6) with respect to the scanning signal (A3) with the lowest resolution of the higher-resolution code group.

7. Position measuring device according to one of the previous claims, characterised in that the evaluation unit (16) for producing the warning signal (F) is an integral component of the measuring device.

## Revendications

1. Dispositif de mesure de position comprenant au moins une unité de palpage (7, 15) pour palper plusieurs pistes à code (3, 4 , 5, 6; 11, 12, 13, 14) avec des résolutions différentes, qui forment au moins deux groupes de codes avec un groupe de codes à résolution plus élevée et un groupe de codes à résolution plus grossière, de telle sorte que des signaux de palpage (A3, A4, A5, A6; A11, A12, A13, A14) avec des périodes de signal différentes sont produits, caractérisé par le fait qu'on surveille un décalage entre au moins un signal de palpage (A3, A4 , A5, A6) du groupe de codes à résolution plus élevée et un signal de palpage (A11, A12, A13, A14) du groupe de codes à résolution plus grossière par rapport à une position de consigne et que, en cas de dépassement d'une plage de tolérances (T1, T2) prédéterminée, un signal d'alarme (F) est délivré.

2. Dispositif de mesure de position selon la revendication 1, caractérisé par le fait que le code des pistes à code (3, 4 , 5, 6; 11, 12, 13, 14) est un code Gray.

3. Dispositif de mesure de position selon la revendication 1 ou 2, caractérisé par le fait qu'on surveille le décalage d'un flanc (K) de l'un des signaux de palpage (A14) du groupe de codes à résolution plus grossière en examinant si le flanc (K) est situé dans une plage de tolérances (T1, T2) déterminée par au moins un des signaux de palpage (A5; A5, A6) du groupe de codes à résolution plus élevée.

4. Dispositif de mesure de position selon la revendication 3, caractérisé par le fait que la plage de tolérances (T1) est la moitié de la période de signal de palpage (A5) qui présente une fréquence double du signal de palpage (A3, A4) avec la plus faible résolution dans le groupe de codes à résolution plus élevée.

5. Dispositif de mesure de position selon la revendication 3, caractérisé par le fait que la plage de tolérances (T2) est déterminée par combinaison logique de plusieurs signaux de palpage (A6, A5) du groupe de codes à résolution plus élevée.

6. Dispositif de mesure de position selon la revendication 5, caractérisé par le fait que la plage de tolérances (T2) est déterminée par une fonction logique OU entre les deux signaux de palpage à résolution plus élevée venant juste après le signal de palpage (A3) avec la résolution la plus basse du groupe de codes à résolution plus élevée.

7. Dispositif de mesure de position selon une des revendications précédentes, caractérisé par le fait que l'unité de traitement (16) pour former le signal d'alarme (F) fait partie intégrante du dispositif de mesure.
